## Europäisches Patentamt
## European Patent Office
## Office européen des brevets

(11) Publication number: **0 098 116**
**B1**

(12) **EUROPEAN PATENT SPECIFICATION**

(45) Date of publication of patent specification: **12.04.89**

(51) Int. Cl.⁴: **H 03 H 9/64**

(21) Application number: **83303644.5**

(22) Date of filing: **24.06.83**

(54) Surface acoustic device.

(30) Priority: **29.06.82 JP 111888/82**

(43) Date of publication of application:
**11.01.84 Bulletin 84/02**

(45) Publication of the grant of the patent:
**12.04.89 Bulletin 89/15**

(84) Designated Contracting States:
**DE FR GB**

(56) References cited:
**GB-A-1 389 023**
**US-A-3 988 703**

**ELECTRONICS LETTERS, vol. 8, no. 4, 24th
February 1972, pages 81-82, London, GB; J.D.
MAINES et al.: "Frequency-dependent
behaviour of an acoustic-surface-wave
multistrip coupler"**

(73) Proprietor: **FUJITSU LIMITED**
**1015, Kamikodanaka Nakahara-ku
Kawasaki-shi Kanagawa 211 (JP)**

(72) Inventor: **Tanji, Shigeo**
**Fujitsu Ibukino-shataku B 202 55-8, Ibukino
Midori-ku Yokohama-shi Kanagawa 227 (JP)**
Inventor: **Wakatsuki, Noboru**
**Nakanoshima-jutaku 3-402 1540-1,
Nakanoshima
Tama-ku Kawasaki-shi Kanagawa 214 (JP)**

(74) Representative: **Rackham, Stephen Neil et al
GILL JENNINGS & EVERY 53-64 Chancery Lane
London WC2A 1HN (GB)**

Courier Press, Leamington Spa, England.

**Description**

The present invention relates to a surface acoustic wave (SAW) device comprising an input-side transducer, an output-side transducer, and an electromechanical coupling means provided therebetween so as to change the propagation path of the surface acoustic wave. More particularly, it relates to a SAW device wherein the electromechanical coupling means is formed in a given shape to obtain the desired stopband characteristics.

SAW devices in accordance with the present invention can be used as filtering devices, signal delaying devices, or the like.

Surface acoustic wave (SAW) devices comprising an electromechanical coupling means include elements called multi-strip lines (or couplers) which consist of a plurality of electrically conductive strips provided between an input-side transducer and an output-side transducer such as to apply the essential surface acoustic waves emitted from the input-side transducer to the output-side transducer and prevent the bulk wave from being applied to the output-side transducer (e.g. US—A—3739290 and US—A—3836876) are already known.

It is known to use a variety of different patterns of connection for the electrically conductive strips of a SAW device. GB—A—1,389,023 discloses a SAW device in which the parallel strips of the electromechanical coupling means are arranged in a repeating pattern. A number of different patterns are disclosed inlcuding ones in which every other conductive strip is connected together and patterns in which every fourth conducting strip is connected together. It is also known that the performance of such electromechanical couplers is frequency dependent and in particular that stopbands caused by strong reflections of the surface wave occur at certain defined frequencies. This phenomenon is discussed by J. D. Maines et al at pages 81 to 82 of Electronics Letters volume 8 No. 4, 24th February 1972. This paper discloses a relationship between the frequency $f_s$ at which strong reflection of the surface wave occurs and the spacing d of the parallel strips of the coupler of the form

$$f_s(n) = nv_s/2d$$

where n is an integer, and $v_s$ is the surface wave velocity.

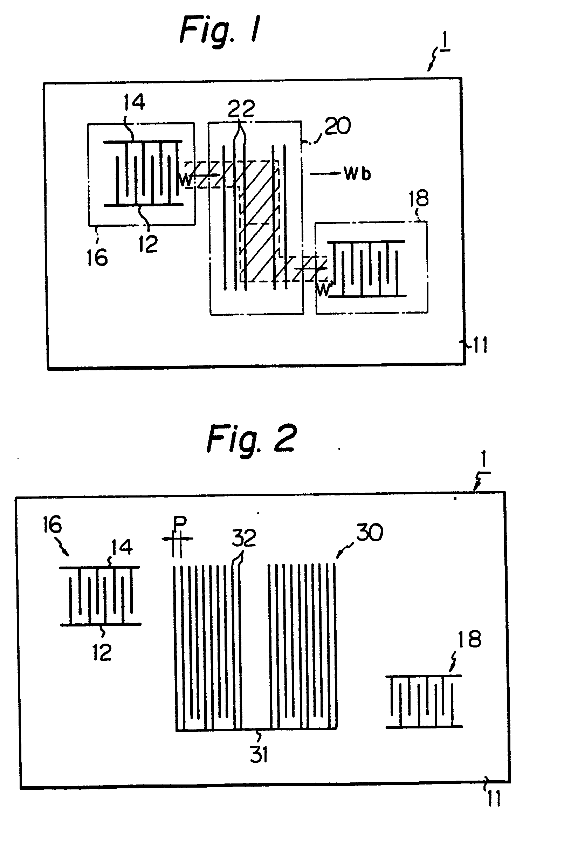

Figure 1 is a plan view of an example of a prior art SAW device. In Figure 1, a SAW device 1 comprises a piezoelectric substrate 11 consisting, for example of lithium niobium oxide (LiNbO₃), an input transducer 16 formed on the surface of the substrate 11, an output transducer 18 formed on the surface of the substrate 11, and the coupler 20 provided between the input transducer 16 and the output transducer 18. The input transducer 16 comprises interdigital electrodes 12 and 14, as shown in Figure 1. The output transducer 18 is formed in a manner similar to the input transducer 16.

When a high-frequency AC power source is applied to the electrodes 12 and 14 of the input transducer 16, surface acoustic waves W are generated in the surface region of the piezoelectric substrate 11 and propagate in the direction shown in Figure 1 (the surface acoustic waves propagating in the opposite direction are not shown). The surface acoustic waves W may include essential surface acoustic waves as well as bulk waves, which may exert an adverse influence on device performance, such as its filtering characteristics. It is preferable that the bulk waves not be applied to the output transducer 18. The coupler 20 is provided so that only the essential wave component is received, and an electrical potential induced at the coupler 20 in response to the received wave. This potential once again generates surface acoustic waves W′, which are applied to the output transducer 18. The coupler 20 includes a plurality of conductive strips 22 formed on the surface of the substrate 11 and in parallel to each other, each of which induces a voltage in response to the waveform signal of the essential component of the surface acoustic waves W. The bulk waves Wb cannot be caught at the strips 22 and propagate forward. The voltages induced at the conductive strips 22 are transmitted to the opposite ends of the strips, where the strips are associated with the substrate 11 so as to generate a secondary surface acoustic wave W′. The output transducer 18 receives the secondary surface acoustic wave W′ and outputs an electrical signal in response to the received wave W′. As mentioned above, the direction of propagation is changed by the coupler 20 as shown and only the essential surface component of the wave is applied to the output transducer 18. This gives the required characteristics, such as a signal delaying feature between the input transducer 16 and the output transducer 18.

The coupler 20 mentioned above has a considerably wide frequency bandwidth. SAW devices in the prior art therefore have such drawbacks as an inability to obtain given filtering characteristics. This is the case, for example, with filters used in television sets, which have a deep trap level on both of the band passes.

An object of the present invention is to provide a surface acoustic wave device that maintains the ability to avoid the influence of the bulk wave and transmit only the essential surface wave, and that provides given filtering characteristics using relatively simple technology.

According to the present invention, a surface acoustic wave device comprising: a piezoelectric substrate; a first electrode means having a set of inter-digitated electrodes formed on the surface of the substrate and generating surface acoustic waves on the surface region of the substrate when a high-frequency AC voltage is applied between the two interdigitated electrodes; a second electrode means having two interdigitated electrodes formed on the surface of the substrate, the centre of the second electrode means being spaced at a distance from the centre of the first electrode means in the direction perpendicular to the direction of surface acoustic wave propagation, and generating an electrical signal between the interdigitated electrodes in response to the received surface acoustic waves; and an electromechanical coupling means having a plurality of electrically conductive strips formed in a repeating pattern on the substrate between the first electrode means and the second electrode means and oriented perpendicular to the direction of surface acoustic wave propagation, the strips being parallel to each other, is characterised in that the repeating pattern has a repeat unit comprising two interconnected adjacent strips followed by at least one unconnected strip and in that the spacing p between adjacent strips is chosen to satisfy the relationship

$$p = \frac{mV}{4f_T k}$$

where
m: number of stopbands (m=1, 2, ..., m)
V: propagation speed of the surface acoustic wave
$f_T$: centre frequency of the stopband
k: an integer (k=1, 2, ...)
the device thereby providing a desired filtering characteristic.

Other objects and features of the present invention will be described in detail with reference to the accompanying drawings.

In the drawings:

Figure 1 illustrates a plan view of an example of a prior surface acoustic wave (SAW) device provided with an electromechanical coupling means;

Figure 2 illustrates a plan view of an embodiment of a SAW device in accordance with the present invention;

Figures 3A and 3B show a principal gain attenuation characteristic of a SAW device in accordance with the present invention;

Figure 4 shows an actual gain attenuation characteristic taken from the SAW device shown in Figure 1;

Figure 5 shows an actual gain attenuation characteristic obtained by the SAW device shown in Figure 2;

Figure 6 shows a stopband feature gained by the electromechanical coupling means formed on the SAW device in Figure 2;

Figure 7 shows a total filtering characteristic obtained by the SAW device shown in Figure 2;

Figure 8 shows plots of insertion losses versus the number of the strips in the electromechanical coupling means of the SAW device in Figure 2;

Figure 9 shows plots of the frequency band versus the number of strips in the SAW device in Figure 2;

Figure 10 illustrates a plan view of an electromechanical coupling means using a conventional configuration;

Figure 11 shows the total attenuation in accordance with the SAW device using the electromechanical coupling means;

Figure 12 shows the characteristic curves corresponding to the curves in Figure 6 for the electromechanical coupling means;

Figure 13 shows the characteristic curves corresponding to the Figure 8 for the SAW device using the electromechanical coupling means shown in Figure 10;

Figure 14 shows the characteristic curves corresponding to the curves in Figure 9 for the SAW device used in the electromechanical coupling means shown in Figure 10;

Figures 15 and 16 are plan views of other embodiments of the electromechanical coupling means of the SAW device shown in Figure 2;

Figure 17 represents the attenuation characteristics of the SAW device using the electromechanical coupling means of Figures 15 and 16;

Figures 18 and 19 illustrate plan views of other embodiments of the electromechanical coupling means of the SAW device shown in Figure 2; and

Figure 20 shows the filtering characteristics of the SAW device using the electromechanical coupling means of Figures 18 and 19.

One example of the present invention is shown in Figure 2. Here, a surface acoustic wave (SAW) device 1 comprises a piezoelectric substrate 11 consisting of, for example, lithium niobium oxide ($LiNbO_3$) on which is provided a first set of electrodes 16 serving as an input transducer, a second set of electrodes 18 serving as an output transducer, and an electromechanical coupling element 30. The electromechanical coupling element 30 comprises a plurality of strips 32 arranged in parallel with each other in a repeating pattern in which two consecutive strips are connected and the following two not connected at the ends thereof adjacent to the second electrode means 18, as shown. The two consecutive unconnected strips are not electrically grounded and are isolated. A common connecting strip 31 is normally grounded, but may be not grounded. The strips 32 and the common connecting strip 31 may be formed by, for example, a vapor deposition process using a conductive material such as aluminium (Al). The two sets of electrodes 16 and 18 may also be formed in this way.

There are provided a plurality of parallel strips 32, the exact number of which depends on the desired reception performance of the surface acoustic waves. In general, many strips are required, because each strip only catches the respective surface acoustic waves in accordance with its reception performance, which depends on the wavelength passing through the corresponding strip, and induces an electrical signal. Beyond a certain number of strips, the reception performance tends to decrease. Performance, manufacturing costs, size and other factors should therefore be taken into account in selecting an optimum strip number. In this example, the preferred strip number is from approximately 100 to 200, as mentioned later.

When n stop bands are required, the center-to-center distance p between the longitudinal strips is defined as follows:

$$p \doteq \frac{1/2\, n \cdot V}{4\, f_T} \qquad (1)$$

where

V: propagation speed of the surface acoustic wave,

$f_T$: center frequency at the required stop band.

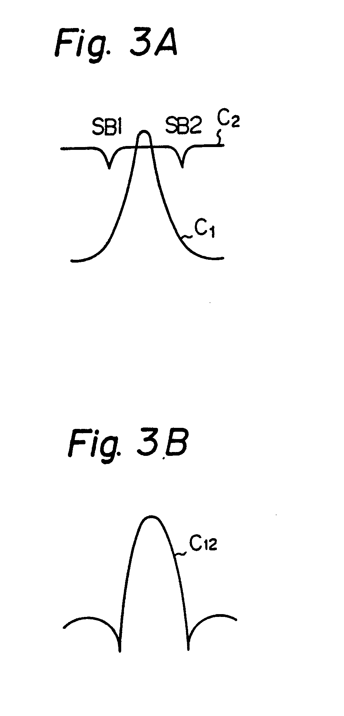

When the pitch p between the strips is defined on the basis of the above relationship, the desired electromechanical coupling element can be formed, this having, for example, one stop band (n=1) or two stop bands (n=2). When n=2, a principal characteristic of stop bands SB1, SB2 is shown in Figure 3A as curve C2. On the other hand, the first set of electrodes 16 and the second set of electrodes 18 have essentially the attenuation characteristic as curve C1 shown in Figure 3A. The total performance of the SAW device in Figure 2 is shown as curve C12 in Figure 3B, which is the summation of curves C1 and C2.

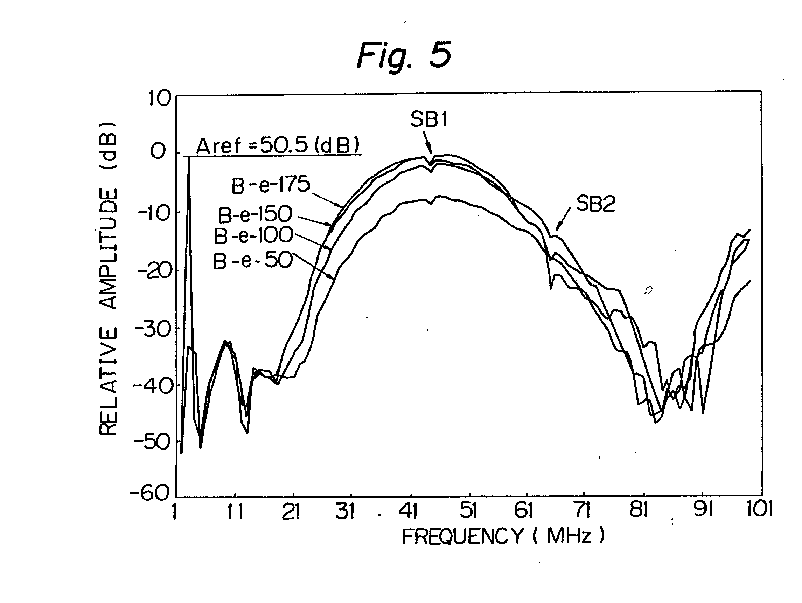

The measured performances of the example mentioned above with reference to the saw device in Figure 2 (type: B-e) are shown in Figures 5—9. Measurements were carried out under the following conditions. Substrate: 128°-rotated Y-cut, X-propagating LiNbO₃; the interdigital electrodes of the first and second set of electrodes 16 and 18 were formed in a one-to-one correspondence; external impedance of the SAW device was 50 Ohms.

Figure 5 shows the total frequency amplitude characteristics of a SAW device (type: B-e); here, curves B-e-50, 100, 150 and 175 are plotted for 50, 100, 150, and 175 strips, respectively. In Figure 5, attenuation relative to the maximum value, i.e., A ref=50.5 dB, is plotted on the vertical axis and frequency on the horizontal axis.

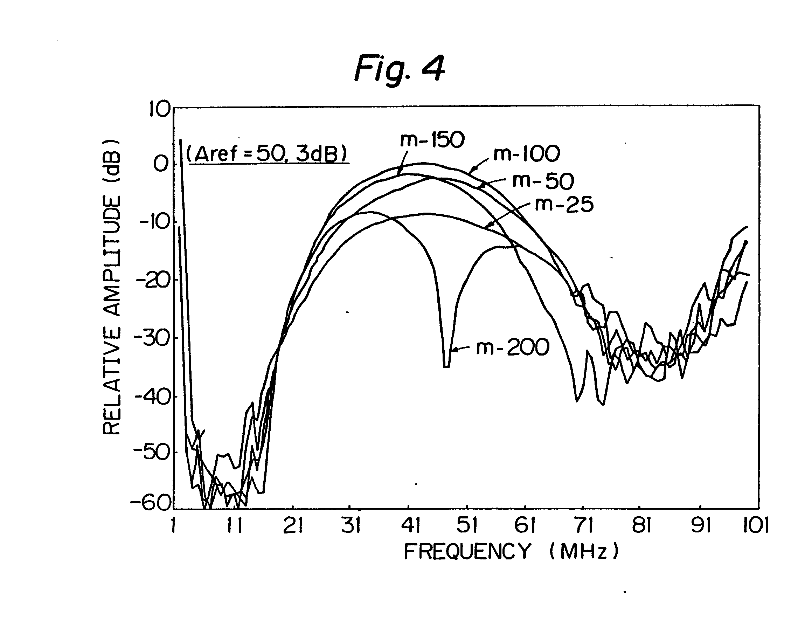

Figure 4 shows the same characteristics as those in Figure 5, obtained in the prior art SAW device shown in Figure 1; here, curves m-25, 50, 100, 150 and 200 represent 25, 50, 100, 150, and 200 strips, respectively.

From a comparison of the characteristics shown in the curves in Figures 4 and 5, it is apparent that first and second stop-bands SB1 and SB2 exist at f≐43 (MHz) and f≐65 (MHz) on the curves in Figure 5.

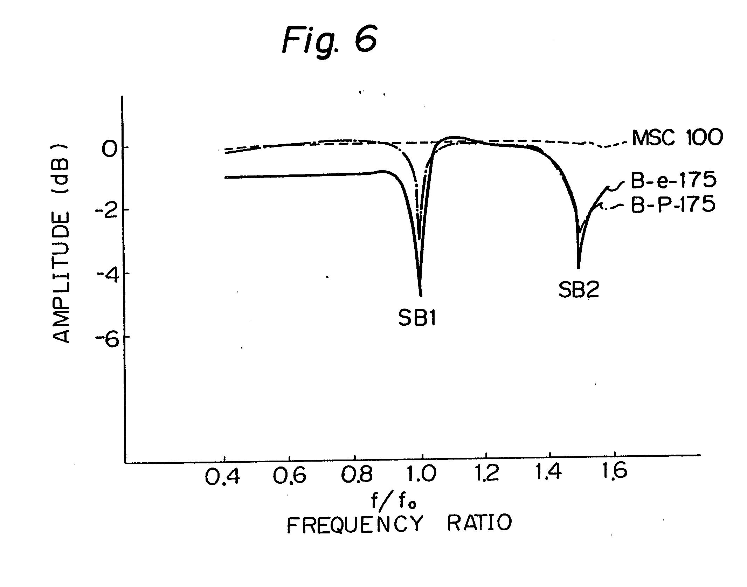

In Figure 3, a general stopband curve in accordance with the present invention is shown as curve C2, while Figure 6 shows an actual stopband feature given by the electromechanical coupling element as curve B-3 175. Curve B-e 175 has two stopbands, SB1 and SB2. Curve MSC 100, for an electromechanical coupling element with 100 strips, shows the measured results for the coupler in Figure 1. No stopbands appear here because the coupler has a broad frequency range; i.e., curve MSC 100 is almost flat.

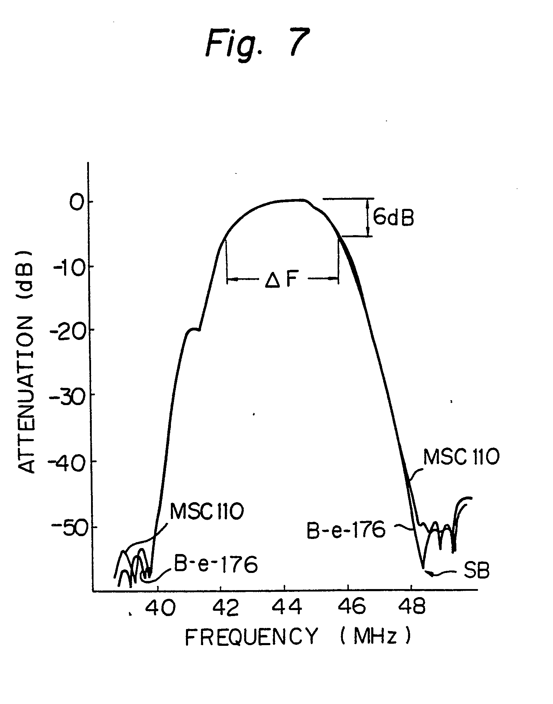

Curve B-e-176 in Figure 7 shows another actual characteristic of the SAW device shown in Figure 2 and corresponding to the characteristic in Figure 5. The conditions of measurement were as follows: strip pitch p mentioned in Expression (1): 20.3 μm; 176 strips; width of the strip: 2000 Å; electrically conductive material: Aluminum (Al); pitch of the interdigital electrodes in the first and set of second electrodes: 22 μm; substrate: 128°-rotated, Y-cut, X-propagating LiNbO₃. Curve MSC 110 in Figure 7 is data obtained for a prior device having a distance between strips of 20.9 μm, and 110 strips. Curves B-e 176 and MSC 110 are the total frequency-attenuation characteristics at a center frequency of 44 MHz and a frequency band width of ±4 MHz.

Curves MSC 110 and B-e 176 in Figure 7 are similar in shape. However, curve B-e 176 for the device in accordance with the present invention has a distinctive stopband SB at frequency 48.5 MHz. This means that curve B-e 176 has an improved rejection performance compared with curve MSC 110, particularly at higher frequency. The SAW device mentioned above is therefore available for use as a filtering device with a center frequency of 44 MHz and a band width of ±4 MHz.

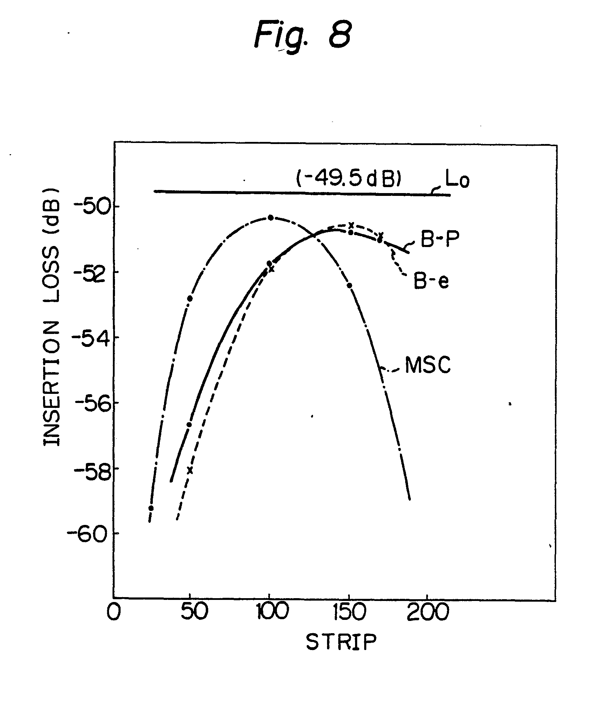

A greater number of strips is required in the present invention (170) than in prior art devices (110), as shown in Figure 7. Yet, the SAW device can obtain a similar frequency-attenuation curve at the desired frequency range. The relationship between the number of strips and the insertion loss is shown in Figure 8. In Figure 8, curve MSC represents the prior art device, curve B-e the SAW device in accordance with the present invention, and straight line $L_0$ represents that of a SAW device without an intermediate electromechanical coupling element. Line $L_0$ has a constant loss —49.5 dB. As seen from Figure 8, the preferred number of strips in the SAW device shown in Figure 2 ranges from approximately 100 to 200.

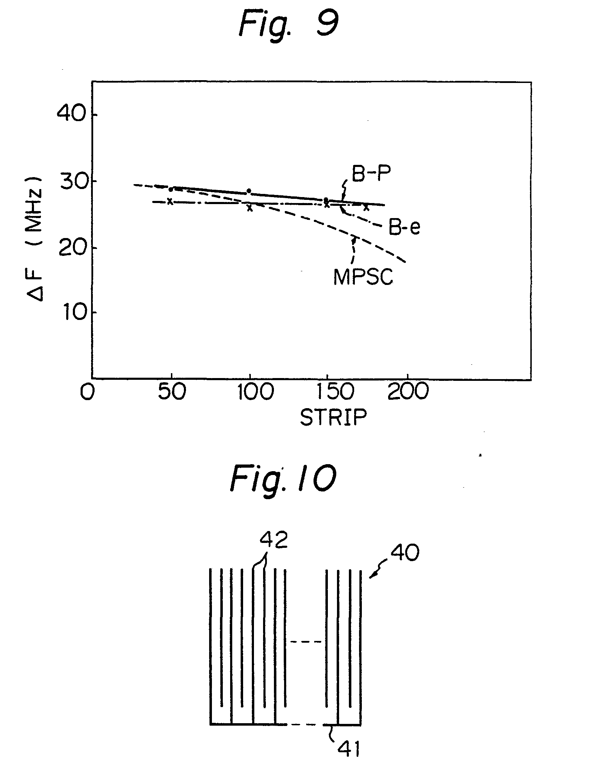

Figure 9 shows the relationship between the frequency band width ΔF, which has a frequency range representing 6 dB down from the maximum value in Figure 7, and the number of strips. In Figure 9, curve MPSC represents the prior device and curve B-e represents the SAW device in accordance with the present invention. It is clear that curve B-e has a lower frequency dependence than the prior art device.

As mentioned above, the SAW device of the present invention shown in Figure 2 requires more strips than in the prior art device in order to obtain the same basic performance, with the exception of the stopband properties. The SAW device in accordance with the present invention, however, can obtain the predetermined stopbands of the predetermined frequencies through the formation of an electromechanical coupling element 30 which contains strips connected in a given manner and at a given distance from each other, depending on expression 1.

SAW devices in accordance with the present invention can thus be used as high-performance filters, such as high performance bandpass filters having two stopbands in television sets, selective rejection filters of predetermined frequencies, and in other applications.

The SAW device shown in Figure 2 is no more difficult to manufacture than devices according to the prior art, and entails about the same manufacturing costs and time.

The principal and scope of the present invention is not limited by the above-described example, which can be accompanied by several other modifications. Several more examples are described below.

Figure 10 shows an electromechanical coupling element 40 having strips connected in a conventional pattern. This coupling element 40 has a plurality of electrically conductive strips 42 arranged in parallel. Here, alternate strips are connected by a common connecting strip 41 at the strip ends near the second set of electrodes 18 (not shown). In this embodiment, the common connecting strip 41 is grounded; however, strip 41 may not be grounded, the effect obtained thereby being similar. Other features of the SAW device are the same as those mentioned above.

The SAW device provided with electromechanical coupling element 40 can be defined by the following relationship;

$$p' \fallingdotseq \frac{mV}{4f_T} \qquad (2)$$

where

p': center-to-center distance between the strips,
m: number of stopbands, m=1,2, . . . , m,
V: propagation speed of the surface acoustic wave,
$f_T$: center frequency at the required stopband.

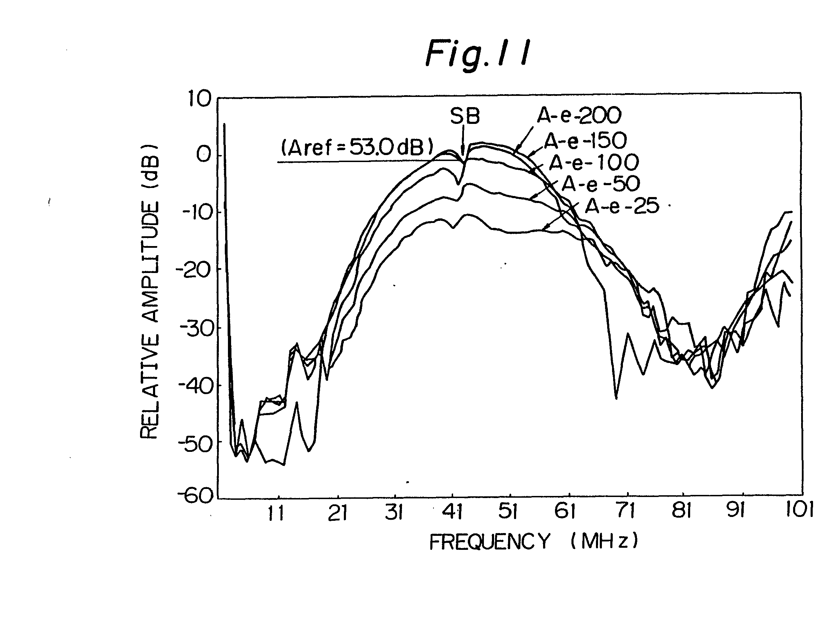

The SAW device provided with the electromechanical coupling means 40 (type: A-e) performs as shown in curve A-e in Figures 11 to 14. The measuring conditions are substantially the same as those for the SAW device in Figure 2.

Characteristics curves A-e in Figure 11 correspond to those in Figure 5, but have only one stopband SB.

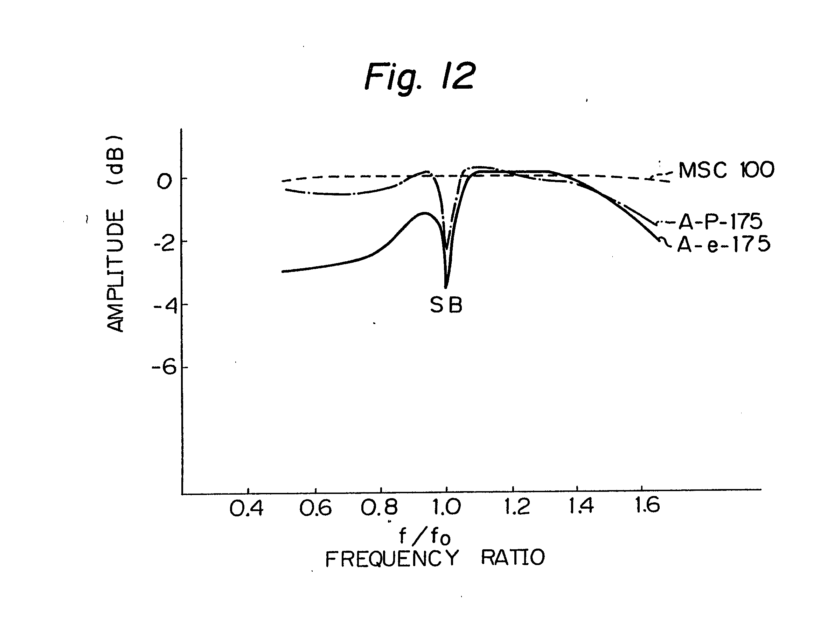

Stopband characteristic curve A-e 175 in Figure 12 corresponds to that in Figure 6.

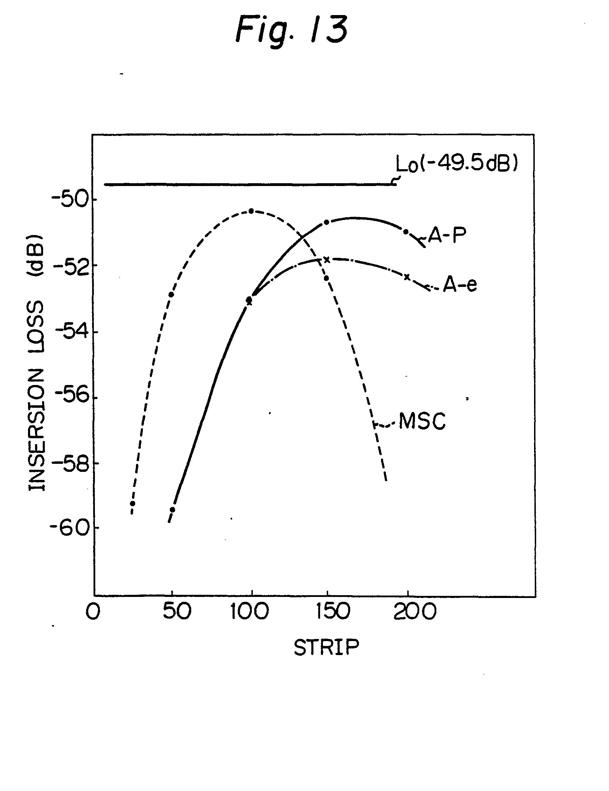

Curve A-e in Figure 13 corresponds to that in Figure 8.

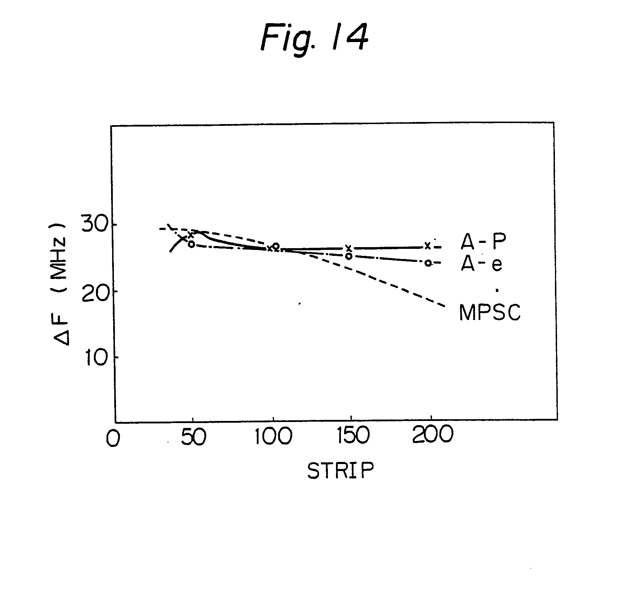

Curve A-e in Figure 14 corresponds to that in Figure 9.

As is apparent from the above description and the performance curves in Figures 11 to 14, SAW devices provided with electromechanical coupling means 40 also have suitable stopbands in the same manner as the SAW device in Figure 2, and maintain the basic performance characteristics of the prior art devices.

The preferred number of strips of the SAW device mentioned above ranges from approximately 100 to 200.

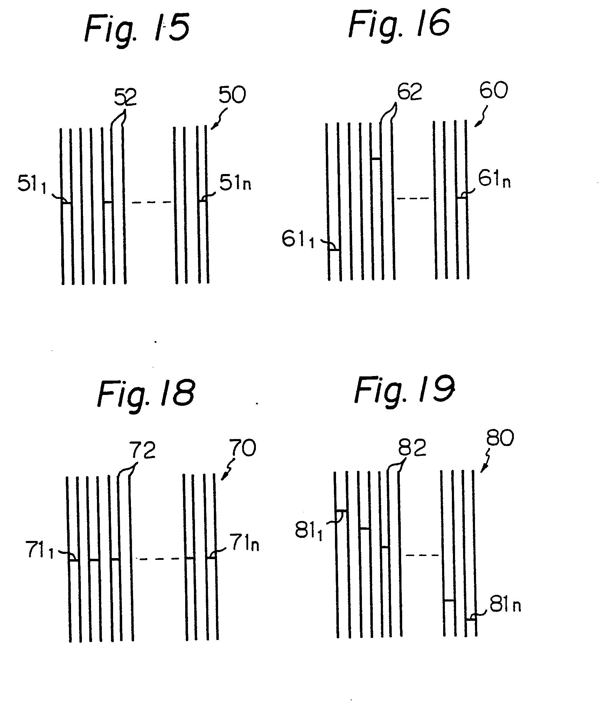

In addition, other embodiments in accordance with the present invention will be shown in Figures 15 and 16. Electromechanical coupling elements 50 and 60 in Figures 15 and 16 have the same connection as the electromechanical coupling elements 30 shown in Figure 2. However, connecting strips $51_1$ to $51_n$ and $61_1$ to $61_n$ thereof are located at different longitudinal positions. Strips $51_1$ to $51_n$ are positioned at the middle of the strips 52 and the strips $61_1$ to $61_n$ are arranged arbitrarily.

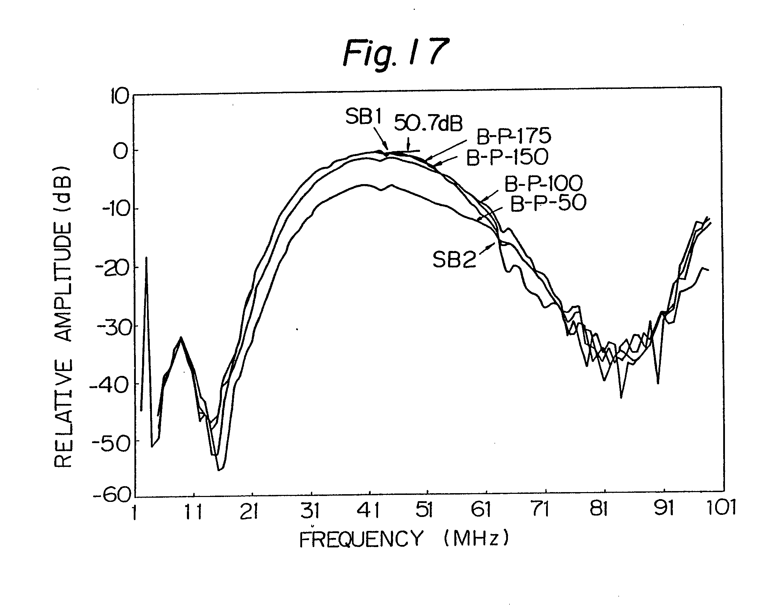

SAW devices containing an electromechanical coupling element 50 or 60 (named B-p type) depend on substantially the same principle as does the device in Figure 2 (B-e type). The measured performances of devices provided with electromechanical coupling means 50 or 60 are shown as curves B-p in Figure 17 corresponding to Figure 5, and curves B-p in Figures 8 and 9.

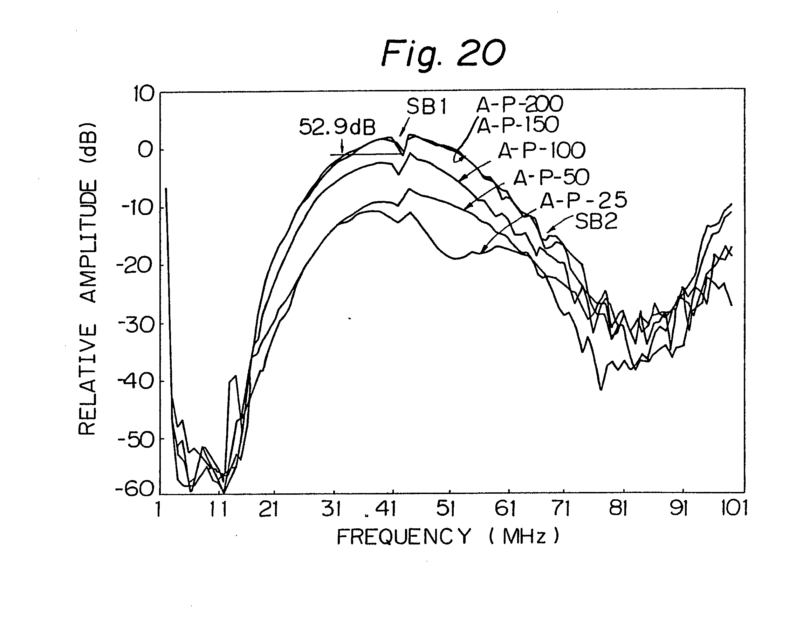

Other embodiments in accordance with the present invention are shown in Figures 18 and 19. The electromechanical coupling elements 70 and 80 in Figures 18 and 19 have different connections from the electromechanical coupling means 40 shown in Figure 10, and connecting strips $71_1$ to $71_n$ and $81_1$ to $81_n$ thereof are located at different longitudinal positions. Strips $71_1$ to $71_n$ are positioned at the middle of the strips 72 and strips $81_1$ to $81_n$ are located at arbitrary positions.

SAW devices with electromechanical coupling elements 70 or 80 (A-p type) depend basically on the same principle as the devices in Figure 10 described above (type A-e). The performances of the devices provided with electromechanical coupling means 70 or 80 were measured as curves A-p in Figure 20, which corresponds to Figure 11, and curves A-p in Figures 12 to 14.

**Claims**

1. A surface acoustic wave device comprising: a piezoelectric substrate (11); a first electrode means (16) having a set of interdigitated electrodes (12, 14) formed on the surface of the substrate and generating surface acoustic waves on the surface region of the substrate when a high-frequency AC voltage is applied between the two interdigitated electrodes; a second electrode means (18) having two interdigitated electrodes formed on the surface of the substrate, the centre of the second electrode means being spaced at a distance from the centre of the first electrode means in the direction perpendicular to the direction of surface acoustic wave propagation, and generating an electrical signal between the interdigitated electrodes in response to the received surface acoustic waves; and an electromechanical coupling means (30) having a plurality of electrically conductive strips (32) formed in a repeating pattern on the substrate between the first electrode means and the second electrode means and oriented perpendicular to the direction of surface acoustic wave propagation, the strips being parallel to each other, characterised in that the repeating pattern has a repeat unit comprising two interconnected adjacent strips (32) followed by at least one unconnected strip and in that the spacing p between adjacent strips is chosen to satisfy the relationship

$$p = \frac{mV}{4f_T k}$$

where

    m: number of stopbands (m=1, 2, . . . , m)
    V: propagation speed of the surface acoustic wave
    $f_T$: centre frequency of the stopband
    k: an integer (k=1, 2, . . .)
the device thereby providing a desired filtering characteristic.

2. A surface acoustic wave device according to claim 1, in which the repeat unit comprises two interconnected adjacent strips (32) followed by one unconnected strip and in which k=1.

3. A surface acoustic wave device according to claim 1, in which the repeat unit comprises two interconnected adjacent strips (32) followed by two adjacent unconnected strips and in which k=2.

4. A surface acoustic wave device according to any one of the preceding claims, in which the electrically conductive strips are spaced at a distance p for which m=1.

5. A surface acoustic wave device according to any one of claims 1 to 3, in which the conductive strips (32) are spaced at a distance p for which m=2.

6. A surface acoustic wave device according to any one of the preceding claims, in which the connection (31, 41) for the strips which are connected is at their ends near the second electrode means (18).

7. A surface acoustic wave device according to any one of the preceding claims, in which the number of electrically conductive strips of the electromechanical coupling means is in the range from 100 to 200.

## Patentansprüche

1. Akkustische Oberflächenwellenvorrichtung mit: einem piezoelektrischem Substrat (11); einer ersten Elektrodeneinrichtung (16), die einen Satz von interdigital angeordneten Elektroden (12, 14) hat, die auf der Oberfläche des Substrats gebildet sind und akkustische Oberflächenwellen auf dem Oberflächenbereich des Substrats erzeugen, wenn eine hochfrequente Wechselspannung zwischen den beiden interdigital angeordneten Elektroden angelegt wird; einer zweiten Elektrodeneinrichtung (18), die zwei interdigital angeordnete Elektroden hat, die auf der Oberfläche des Substrats gebildet sind, wobei das Zentrum der zweiten Elektrodeneinrichtung einen Abstand von dem Zentrum der ersten Elektrodeneinrichtung in der Richtung senkrecht zu der Ausbreitungsrichtung der akkustischen Oberflächenwelle aufweist, und ein elektrisches Signal zwischen den interdigitalen Elektroden in Abhängigkeit von dem empfangenen akkustischen Oberflächenwellen erzeugt; und einer elektromechanischen Kopplungseinrichtung (30), die eine Vielzahl von elektrisch leitenden Streifen (32) hat, die in einem Wiederholungsmuster auf dem Substrat zwischen der ersten Elektrodeneinrichtung und der zweiten Elektrodeneinrichtung geformt sind und senkrecht zu der Ausbreitungsrichtung der akkustischen Oberflächenwelle orientiert sind, wobei die Streifen parallel zu einander sind, dadurch gekennzeichnet, daß das Wiederholungsmuster eine Wiederholungseinheit hat, die zwei miteinander verbundene benachbarte Streifen (32) umfaßt, auf die wenigstens ein nicht verbundenen Streifen folgt, und daß der Abstand p zwischen benachbarten Streifen so gewählt ist, daß er die Gleichung

$$p = \frac{mV}{4f_T k}$$

erfullt, mit

    m: Anzahl der Sperrbereiche (m=1, 2, . . . , m)
    V: Ausbreitungsgeschwindigkeit der akkustischen Oberflächenwelle
    $f_T$: Zentralfrequenz des Sperrbereiches
    k: eine ganze Zahl (k=1, 2, . . .)
wodurch die Vorrichtung eine gewünsche Filtercharakteristik hat.

2. Akkustische Oberflächenwellenvorrichtung nach Anspruch 1, bei der die Wiederholungseinheit zwei miteinander verbundene benachbarte Streifen (32) umfaßt, auf die ein nicht verbundener Streifen folgt, und bei der k=1 ist.

3. Akkustische Oberflächenwellenvorrichtung nach Anspruch 1, bei der die Wiederholungseinheit zwei miteinander verbundene benachbarte Streifen (32) umfaßt, auf die ein nicht verbundener Streifen folgt, und bei der k=2 ist.

4. Akkustische Oberflächenwellenvorrichtung nach einem der vorhergehenden Ansprüche, bei der die elektrisch leitenden Streifen einen Abstand p voneinander aufweisen, für den m=1 ist.

5. Akkustische Oberflächenwellenvorrichtung nach einem der Ansprüche 1 bis 3, bei der die leitenden Streifen (32) einen Abstand p, für den m=2 ist, voneinander aufweisen.

6. Akkustische Oberflächenwellenvorrichtung nach einem der vorhergehenden Ansprüche, bei der die Verbindung (31, 41) für die Streifen, die verbunden sind, an ihren ist nahe der zweiten Elektrodeneinrichtungen (18) ist.

7. Akustische Oberflächenwellenvorrichtung nach einem der vorhergehenden Ansprüche, bei der die Anzahl der elektrisch leitenden Streifen der elektromechanischen Kopplungseinrichtung im Bereich von 100 bis 200 ist.

## Revendications

1. Un dispositif à ondes acoustiques de surface comprenant: un substrat piézoélectrique (11); une première structure d'électrodes (16) comprenant un ensemble d'électrodes interdigitées (12, 14) formées sur la surface du substrat et produisant des ondes acoustiques de surface dans la région de surface du substrat, lorsqu'une tension alternative de haute fréquence est appliquée entre les deux électrodes interdigitées; une seconde structure d'électrodes (18) comportant deux électrodes interdigitées qui sont formées sur la surface du substrat, le centre de la seconde structure d'électrodes se trouvant à une certaine distance du centre de la première structure d'électrodes dans la direction perpendiculaire à la direction de propagation des ondes acoustiques de surface, et la seconde structure d'électrodes produisant un signal électrique entre les électrodes interdigitées, sous l'effet d'ondes acoustiques de surface reçues; et des moyens de couplage électromécaniques (30) comprenant un ensemble de bandes conductrices de l'électricité (32) formées selon une configuration répétitive sur le substrat, entre la première structure d'électrodes et la seconde structure d'électrodes, et orientées perpendiculairement à la direction de propagation des ondes acoustiques de surface, les bandes étant mutuellement parallèles, caractérisé en ce que la configuration répétitive présente un motif de répétition unitaire comprenant deux bandes adjacentes interconnectées (32) suivies par au moins une bande non connectée, et en ce que l'écartement p entre des bandes adjacentes est choisi pour satisfaire la relation:

$$p = \frac{mV}{4f_T k}$$

dans laquelle

m: nombre de bandes de fréquence atténuées (m=1, 2, . . . , m)

V: vitesse de propagation de l'onde acoustique de surface

$f_T$: fréquence centrale de la bande de fréquence atténuée

k: un entier (k=1, 2, . . .)

le dispositif procurant ainsi une caractéristique de filtrage désirée.

2. Un dispositif à ondes acoustiques de surface selon la revendication 1, dans lequel le motif de répétition unitaire comprend deux bandes adjacentes interconnectées (32) suivies par une bande non connectée, et dans lequel k=1.

3. Un dispositif à ondes acoustiques de surface selon la revendication 1, dans lequel le motif de répétition unitaire comprend deux bandes adjacentes interconnectées (32) suivies par deux bandes adjacentes non connectées, et dans lequel k=2.

4. Un dispositif à ondes acoustiques de surface selon l'une quelconque des revendications précédentes, dans lequel les bandes conductrices de l'électricité sont séparées par une distance p pour laquelle m=1.

5. Un dispositif à ondes acoustiques de surface selon l'une quelconque des revendications 1 à 3, dans lequel les bandes conductrices (32) sont séparées par une distance p pour laquelle m=2.

6. Un dispositif à ondes acoustiques de surface selon l'une quelconque des revendications précédentes, dans lequel la connexion (31, 41) pour les bandes qui sont connectées se trouve aux extrémités de ces bandes proches de la seconde structure d'électrodes (18).

7. Un dispositif à ondes acoustiques de surface selon l'une quelconque des revendications précédentes, dans lequel le nombre de bandes conductrices de l'électricité des moyens de couplage électromécaniques est compris dans la plage allant de 100 à 200.

## Fig. 1

## Fig. 2

# Fig. 3A

# Fig. 3.B

Fig. 4

EP 0 098 116 B1

Fig. 5

FREQUENCY ( MHz )

EP 0 098 116 B1

# Fig. 6

EP 0 098 116 B1

## Fig. 7

# Fig. 8

Fig. 9

Fig. 10

Fig.11

Fig. I2

EP 0 098 116 B1

## Fig. 13

# Fig. 14

## Fig. 15

## Fig. 16

## Fig. 18

## Fig. 19

Fig. 17

## Fig. 20